# EUROPEAN PATENT APPLICATION

(11) **EP 3 886 193 A1**
(43) Date of publication of application: **29.09.2021**
(21) Application number: 19887271.5
(22) Date of filing: 20.06.2019
(51) Int. Cl.: H01L 51/46, H01L 51/44

(54) **SOLAR BATTERY**

(30) Priority: 20.11.2018 JP 2018217405
(71) Applicant: Panasonic Intellectual Property Management Co., Ltd., Osaka-shi, Osaka 540-6207 (JP)
(72) Inventor: YOKOYAMA Tomoyasu, Osaka-shi Osaka 540-6207 (JP); MATSUI Taisuke, Osaka-shi Osaka 540-6207 (JP)
(74) Representative: Grünecker Patent- und Rechtsanwälte PartG mbB
(86) International application number: PCT/JP2019/024408
(87) International publication number: WO 2020/105207

(57) **Abstract**

The present disclosure provides a solar cell including a first electrode, a second electrode, a photoelectric conversion layer disposed between the first electrode and the second electrode, and an electron transport layer disposed between the first electrode and the photoelectric conversion layer. At least one of the first electrode and the second electrode has a light-transmitting property. The photoelectric conversion layer contains a perovskite compound composed of a monovalent cation, a Sn cation, and a halogen anion. The electron transport layer contains an electron transport material containing niobium oxide. The niobium oxide is amorphous.

## Description

### Technical Field

The present disclosure relates to a solar cell.

### Background Art

In recent years, perovskite solar cells have been studied and developed. Such a perovskite solar cell employs, as a photoelectric conversion material, a perovskite compound represented by a chemical formula ABX₃ (where A is a monovalent cation, B is a divalent cation, and X is a halogen anion).

Non Patent Literature 1 and Patent Literature 1 disclose use of, as the photoelectric conversion material of a perovskite solar cell, a perovskite compound represented by a chemical formula CH₃NH₃SnI₃ (hereafter, referred to as "MASnl3"). Non Patent Literature 1 and Patent Literature 1 also disclose a perovskite compound represented by a chemical formula (NH₂)₂CHSnI₃ (hereafter, referred to as "FASnI₃").

### Citation List

### Patent Literature

Patent Literature 1: Japanese Unexamined Patent Application Publication No. 2017-17252

### Non Patent Literature

Non-Patent Literature 1: Shuyan Shao et. Al. "Highly Reproducible Sn-Based Hybrid Perovskite Solar Cells with 9% Efficiency", Advanced Energy Materials, 2018, Vol. 8, 1702019
Non-Patent Literature 2: Atsushi Kogo et al., "Nb2O5Blocking Layer for High Open-circuit Voltage Perovskite Solar Cells", Chem. Lett., 2015, Vol. 44, 829 - 830

### Summary of Invention

### Technical Problem

An object of the present disclosure is to provide a solar cell that has a high photoelectric conversion efficiency.

### Solution to Problem

The present disclosure provides a solar cell including:
a first electrode;
a second electrode;
a photoelectric conversion layer disposed between the first electrode and the second electrode; and
an electron transport layer disposed between the first electrode and the photoelectric conversion layer,
wherein at least one of the first electrode and the second electrode has a light-transmitting property,
the photoelectric conversion layer contains a perovskite compound composed of a monovalent cation, a Sn cation, and a halogen anion,
the electron transport layer contains an electron transport material containing niobium oxide, and
the niobium oxide is amorphous.

### Advantageous Effects of Invention

The present disclosure provides a solar cell that has a high photoelectric conversion efficiency.

### Brief Description of Drawings

[Fig. 1] Fig. 1 is a graph illustrating measured values of the photoelectric conversion efficiency of a lead-based perovskite solar cell and a tin-based perovskite solar cell produced by the inventors of the present invention.
[Fig. 2] Fig. 2 is a graph illustrating the relationship among (i) variations in the energy offset between the photoelectric conversion layer and the electron transport layer of a solar cell, (ii) the voltage of the solar cell, and (iii) the electric current density of the solar cell.
[Fig. 3] Fig. 3 is a cross-sectional view of a solar cell according to an embodiment.
[Fig. 4] Fig. 4 is a graph illustrating X-ray diffraction patterns of samples in Example 3 and Comparative Example 7.

### Description of Embodiments

### <Definition of terms>

In this Description, the term "perovskite compound" means a perovskite crystal structure represented by a chemical formula ABX₃ (where A is a monovalent cation, B is a divalent cation, and X is a halogen anion) and a structure having crystals similar to those of the perovskite crystal structure.

In this Description, the term "tin-based perovskite compound" means a perovskite compound that contains tin.

In this Description, the term "tin-based perovskite solar cell" means a solar cell that contains a tin-based perovskite compound as a photoelectric conversion material.

In this Description, the term "lead-based perovskite compound" means a perovskite compound that contains lead.

In this Description, the term "lead-based perovskite solar cell" means a solar cell that contains a lead-based perovskite compound as a photoelectric conversion material.

Hereinafter, embodiments according to the present disclosure will be described in detail with reference to drawings.

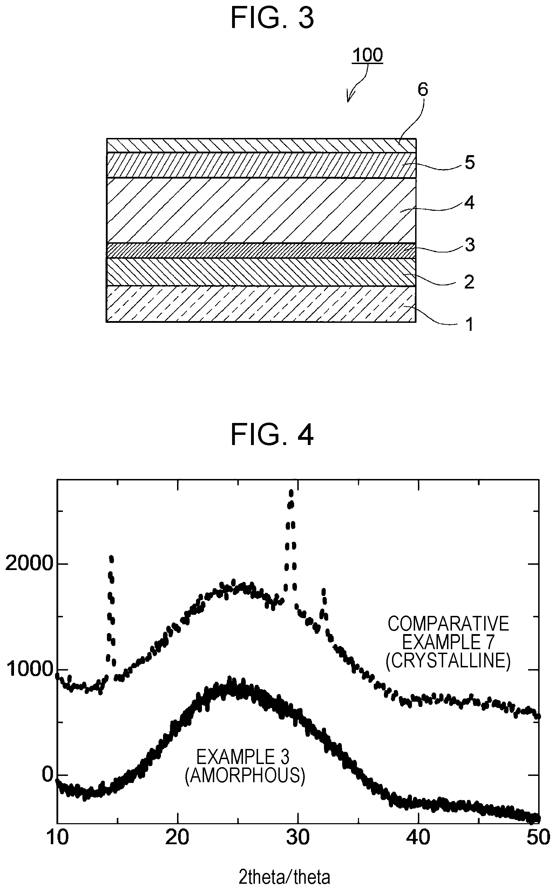

Fig. 3 is a sectional view of a solar cell 100 according to an embodiment.

As illustrated in Fig. 3, the solar cell 100 according to this embodiment includes a first electrode 2, a second electrode 6, a photoelectric conversion layer 4 disposed between the first electrode 2 and the second electrode 6, and an electron transport layer 3 disposed between the first electrode 2 and the photoelectric conversion layer 4.

The first electrode 2 faces the second electrode 6 such that the electron transport layer 3 and the photoelectric conversion layer 4 are positioned between the first electrode 2 and the second electrode 6. At least one of the first electrode 2 and the second electrode 6 has a light-transmitting property. In this Description, the term "electrode has a light-transmitting property" means that, of light having wavelengths of 200 to 2000 nm, greater than or equal to 10% of light having a wavelength passes through the electrode.

### (Photoelectric conversion layer 4)

The photoelectric conversion layer 4 contains, as a photoelectric conversion material, a perovskite compound composed of a monovalent cation, a Sn cation, and a halogen anion. The photoelectric conversion material is a light absorption material.

In this embodiment, the perovskite compound can be a compound represented by a composition formula ABX₃ (where A is a monovalent cation, B is a divalent cation including a Sn cation, and X is a halogen anion).

In conformity with the commonly used designations for perovskite compounds, in this Description, A, B, and X are also respectively referred to as the A site, the B site, and the X site.

In this embodiment, the perovskite compound can have a perovskite crystal structure represented by a composition formula ABX₃ (where A is a monovalent cation, B is a Sn cation, and X is a halogen anion). As an example, a monovalent cation is positioned at the A site, Sn²⁺ is positioned at the B site, and a halogen anion is positioned at the X site.

The A site, the B site, and the X site may each be occupied by a plurality of ion species.

The B site includes a Sn cation, namely, Sn²⁺.

### (A site)

The monovalent cation positioned at the A site is not limited. Examples of the monovalent cation A include organic cations and alkali metal cations. Examples of the organic cations include a methylammonium cation (specifically, CH₃NH₃⁺), a formamidinium cation (specifically, NH₂CHNH₂⁺), a phenylethylammonium cation (specifically, C₆H₅C₂H₄NH₃⁺), and a guanidinium cation (specifically, CH₆N₃⁺). Examples of the alkali metal cations include a cesium cation (specifically, Cs⁺). In order to achieve a high photoelectric conversion efficiency, the monovalent cation A desirably includes a formamidinium cation.

The monovalent cation positioned at the A site may be composed of two or more cation species.

The A site may mainly include a formamidinium cation. The sentence "the A site mainly includes a formamidinium cation" means that the formamidinium cation has the highest molar amount ratio relative to the total molar amount of the monovalent cations. The A site may be substantially solely composed of the formamidinium cation.

### (X site)

The halogen anion positioned at the X site is, for example, an iodide ion. The halogen anion positioned at the X site may be composed of two or more halogen ion species. In order to achieve a high photoelectric conversion efficiency, the halogen anion positioned at the X site desirably includes, for example, an iodide ion.

The X site may mainly include an iodide ion. The sentence "the halogen anion mainly includes an iodide ion" means that the iodide ion has the highest molar amount ratio relative to the total molar amount of the halogen anions. The X site may be substantially solely composed of an iodide ion.

### (Photoelectric conversion layer 4)

The photoelectric conversion layer 4 may include, in addition to a photoelectric conversion material, another material. For example, the photoelectric conversion layer 4 may further contain a quencher substance for reducing the defect density of the perovskite compound. The quencher substance is a fluorinated compound such as tin fluoride. The molar ratio of the quencher substance to the photoelectric conversion material may be greater than or equal to 5% and less than or equal to 20%.

The photoelectric conversion layer 4 may mainly contain a perovskite compound composed of a monovalent cation, a Sn cation, and a halogen anion.

The sentence "the photoelectric conversion layer 4 mainly contains a perovskite compound composed of a monovalent cation, a Sn cation, and a halogen anion" means that the photoelectric conversion layer 4 contains greater than or equal to 70 mass% (desirably greater than or equal to 80 mass%) of the perovskite compound composed of a monovalent cation, a Sn cation, and a halogen anion.

The photoelectric conversion layer 4 may contain an impurity. The photoelectric conversion layer 4 may contain, in addition to the perovskite compound, another compound.

The photoelectric conversion layer 4 may have a thickness of greater than or equal to 100 nm and less than or equal to 10 µm, desirably a thickness of greater than or equal to 100 nm and less than or equal to 1000 nm. The thickness of the photoelectric conversion layer 4 depends on the amount of light it absorbs.

### (Electron transport layer 3 containing niobium oxide)

The electron transport layer 3 contains an electron transport material containing niobium oxide. The energy level of the bottom of the conduction band of the electron transport material containing niobium oxide and the energy level of the bottom of the conduction band of a tin-based perovskite compound have a small difference therebetween. For example, the absolute value of this difference is less than 0.3 eV. Because of this small difference, the electron transport material containing niobium oxide is advantageous.

As demonstrated in Comparative Example 2 to Comparative Example 5 described later, solar cells that include an electron transport material formed of an oxide other than niobium oxide or titanium oxide (such as ZrO₂, Al₂O₃, ZnO, or Ta₂O₅) have a very low photoelectric conversion efficiency of 0%. Stated another way, the solar cells including an electron transport material formed of an oxide other than niobium oxide or titanium oxide do not function as solar cells.

The niobium oxide contained in the electron transport layer 3 is amorphous. As demonstrated in Comparative Example 7 described later, when the niobium oxide contained in the electron transport layer 3 is crystalline, the photoelectric conversion efficiency lowers to a small value of less than 1%.

Stated another way, in the case of using, as the electron transport material, niobium oxide, in order to achieve a high photoelectric conversion efficiency of greater than or equal to 1%, niobium oxide needs to be amorphous.

In order to achieve a photoelectric conversion efficiency of greater than or equal to 2%, as demonstrated in Example 1 to Example 4 described later, the electron transport layer 3 desirably has a thickness of greater than or equal to 8 nm and less than or equal to 350 nm. As demonstrated in Example 5 described later, when the electron transport layer 3 has a thickness of less than 8 nm, the photoelectric conversion efficiency is greater than or equal to 1% and less than 2%. On the other hand, as demonstrated in Example 6 described later, even when the electron transport layer has a thickness of greater than 350 nm, the photoelectric conversion efficiency is greater than or equal to 1% and less than 2%.

The solar cell that includes the electron transport layer 3 having a thickness of greater than or equal to 8 nm and less than or equal to 350 nm and formed of amorphous niobium oxide has a photoelectric conversion efficiency equal to or greater than that of a solar cell that includes an electron transport layer formed of titanium oxide (refer to Comparative Example 1 described later).

In order to increase the photoelectric conversion efficiency, the electron transport layer 3 desirably has a thickness of greater than or equal to 10 nm and less than or equal to 350 nm, more desirably has a thickness of greater than or equal to 50 nm and less than or equal to 350 nm.

The energy level at the bottom of the conduction band of the electron transport material containing niobium oxide may be greater than -3.9 eV and less than -3.1 eV with respect to the vacuum level.

The niobium oxide contained in the electron transport material may be represented by a composition formula Nb₂₍₁₊ₓ₎O₅₍₁₋ₓ₎. The value of x may be greater than or equal to -0.05 and less than or equal to +0.05. The value of x can be measured by X-ray photoelectron spectroscopy (hereafter, referred to as "XPS method"), energy dispersive X-ray analysis (hereafter, referred to as "EDX method"), inductively coupled plasma emission spectrometry (hereafter, referred to as "ICP-OES method"), or Rutherford backscattering spectroscopy (hereafter, referred to as "RBS method").

In order to achieve a high photoelectric conversion efficiency, in the niobium oxide contained in the electron transport material, the molar ratio of niobium to oxygen (namely, a Nb/O molar ratio) may be greater than or equal to 0.36 and less than or equal to 0.41. The molar ratio can be measured also by the XPS method, the EDX method, the ICP-OES method, or the RBS method.

In order to achieve a high photoelectric conversion efficiency, the niobium oxide contained in the electron transport material may be Nb₂O₅.

The electron transport layer 3 may contain a compound other than niobium oxide. The electron transport layer 3 may mainly contain niobium oxide. The electron transport layer 3 may be substantially composed of niobium oxide. The electron transport layer 3 may be composed of niobium oxide alone.

The sentence "the electron transport layer 3 mainly contains niobium oxide" means that the electron transport layer 3 contains greater than or equal to 50 mol% (desirably, greater than or equal to 60 mol%) of niobium oxide.

The sentence "the electron transport layer 3 is substantially composed of niobium oxide" means that the electron transport layer 3 contains greater than or equal to 90 mol% (desirably, greater than or equal to 95 mol%) of niobium oxide.

The electron transport material other than niobium oxide may be a material publicly known as an electron transport material for solar cells. Hereafter, for the purpose of differentiation, niobium oxide will be referred to as a first electron transport material, and the electron transport material other than niobium oxide will be referred to as a second electron transport material. The second electron transport material is also contained in the electron transport layer 3.

The second electron transport material may be a semiconductor having a band gap of greater than or equal to 3.0 eV. When the electron transport layer 3 contains the semiconductor having a band gap of greater than or equal to 3.0 eV, visible light and infrared light pass through the substrate 1, the first electrode 2, and the electron transport layer 3 to reach the photoelectric conversion layer 4. Examples of the semiconductor having a band gap of greater than or equal to 3.0 eV include organic or inorganic n-type semiconductors.

Examples of the organic n-type semiconductors include imide compounds, quinone compounds, fullerene, and fullerene derivatives.

Examples of the inorganic n-type semiconductors include metal oxides, metal nitrides, and perovskite oxides.

Examples of the metal oxides include oxides of Cd, Zn, In, Pb, Mo, W, Sb, Bi, Cu, Hg, Ti, Ag, Mn, Fe, V, Sn, Zr, Sr, Ga, Si, or Cr. TiO₂ is desirable.

Examples of the metal nitrides include GaN.

Examples of the perovskite oxides include SrTiO₃ and CaTiO₃.

The electron transport layer 3 may be in contact with the photoelectric conversion layer 4. Alternatively, the electron transport layer 3 may not be in contact with the photoelectric conversion layer 4. When the electron transport layer 3 is in contact with the photoelectric conversion layer 4, the electron transport material containing niobium oxide may be disposed at a surface of the electron transport layer 3, the surface being in contact with the photoelectric conversion layer 4.

The electron transport layer 3 may be composed of a plurality of layers formed of different electron transport materials, respectively. When the electron transport layer 3 is composed of a plurality of layers, a layer in contact with the photoelectric conversion layer 4 can contain an electron transport material containing niobium oxide.

As illustrated in Fig. 3, in the solar cell 100, on the substrate 1, the first electrode 2, the electron transport layer 3, the photoelectric conversion layer 4, the hole transport layer 5, and the second electrode 6 are stacked in this order. The solar cell 100 may not include the substrate 1. The solar cell 100 may not include the hole transport layer 5.

### (Substrate 1)

The substrate 1 supports the first electrode 2, the photoelectric conversion layer 4, and the second electrode 6. The substrate 1 may be formed of a transparent material. The substrate 1 is, for example, a glass substrate or a plastic substrate. The plastic substrate is, for example, a plastic film. When the first electrode 2 has sufficient strength, the first electrode 2 supports the photoelectric conversion layer 4 and the second electrode 6. In that case, the solar cell 100 may not necessarily include the substrate 1.

### (First electrode 2 and second electrode 6)

The first electrode 2 and the second electrode 6 have electric conductivity. At least one of the first electrode 2 and the second electrode 6 has a light-transmitting property. Such an electrode having a light-transmitting property can transmit light in the visible-light region to the near-infrared region. The electrode having a light-transmitting property can be formed of a material that is transparent and has electric conductivity.

Examples of such a material include:
(i) titanium oxide doped with at least one selected from the group consisting of lithium, magnesium, niobium, and fluorine,
(ii) gallium oxide doped with at least one selected from the group consisting of tin and silicon,
(iii) gallium nitride doped with at least one selected from the group consisting of silicon and oxygen,
(iv) indium-tin-oxide,
(v) tin oxide doped with at least one selected from the group consisting of antimony and fluorine,
(vi) zinc oxide doped with at least one of boron, aluminum, gallium, and indium, and
(vii) composites of the foregoing.

The electrode having a light-transmitting property can be formed using an opaque material so as to have a pattern that transmits light. The pattern that transmits light is, for example, a linear, wavy-line, or grid pattern or a punching metal pattern in which a large number of fine through-holes are regularly or irregularly arranged. When the electrode having a light-transmitting property has such a pattern, light passes through an area not covered with the electrode material. Examples of the opaque material include platinum, gold, silver, copper, aluminum, rhodium, indium, titanium, iron, nickel, tin, zinc, and alloys of the foregoing. Alternatively, an electrically conductive carbon material may be used as the opaque material.

The solar cell 100 includes the electron transport layer 3 between the photoelectric conversion layer 4 and the first electrode 2, and hence the first electrode 2 may be formed so as not to have a property of blocking holes from the photoelectric conversion layer 4. Thus, the first electrode 2 may be formed of a material that forms an ohmic contact with the photoelectric conversion layer 4.

When the solar cell 100 does not include the hole transport layer 5, the second electrode 6 is formed of, for example, a material that has a property of blocking electrons from the photoelectric conversion layer 4. In this case, the second electrode 6 is not in an ohmic contact with the photoelectric conversion layer 4. The property of blocking electrons from the photoelectric conversion layer 4 is a property of transmitting only holes and not transmitting electrons generated in the photoelectric conversion layer 4. The material having a property of blocking electrons has a Fermi energy lower than the energy level of the bottom of the conduction band of the photoelectric conversion layer 4. The Fermi energy of the material having a property of blocking electrons may be lower than the Fermi energy level of the photoelectric conversion layer 4. Examples of the material having a property of blocking electrons include platinum, gold, and carbon materials such as graphene.

When the solar cell 100 includes the hole transport layer 5 between the photoelectric conversion layer 4 and the second electrode 6, the second electrode 6 may be formed so as not to have a property of blocking electrons from the photoelectric conversion layer 4. In this case, the second electrode 6 may be in an ohmic contact with the photoelectric conversion layer 4.

The material having a property of blocking holes from the photoelectric conversion layer 4 may not necessarily have a light-transmitting property. The material having a property of blocking electrons from the photoelectric conversion layer 4 may also not necessarily have a light-transmitting property. Thus, when such a material is used to form the first electrode 2 or the second electrode 6, the first electrode 2 or the second electrode 6 has the above-described pattern formed such that light passes through the first electrode 2 or the second electrode 6.

The first electrode 2 and the second electrode 6 may each have a light transmittance of greater than or equal to 50%, or greater than or equal to 80%. The wavelength of light transmitted by such an electrode depends on the absorption wavelength of the photoelectric conversion layer 4. The first electrode 2 and the second electrode 6 each have a thickness in a range of, for example, greater than or equal to 1 nm and less than or equal to 1000 nm.

### (Hole transport layer 5)

The hole transport layer 5 is formed of an organic substance or an inorganic semiconductor. Examples of a representative organic substance used for the hole transport layer 5 include 2,2',7,7'-tetrakis-(N,N-di-p-methoxyphenylamine)9,9'-spirobifluorene (hereafter, referred to as "spiro-OMeTAD"), poly[bis(4-phenyl)(2,4,6-trimethylphenyl)amine] (hereafter, referred to as "PTAA"), poly(3-hexylthiophene-2,5-diyl) (hereafter, referred to as "P3HT"), poly(3,4-ethylenedioxythiophene) (hereafter, referred to as "PEDOT"), and copper phthalocyanine (hereafter, referred to as "CuPC").

Examples of the inorganic semiconductor include Cu₂O, CuGaO₂, CuSCN, Cul, NiOₓ, MoOₓ, V₂O₅, and carbon materials such as graphene oxide.

The hole transport layer 5 may include a plurality of layers that are different from each other in material.

The hole transport layer 5 may have a thickness of greater than or equal to 1 nm and less than or equal to 1000 nm, or greater than or equal to 10 nm and less than or equal to 500 nm, or greater than or equal to 10 nm and less than or equal to 50 nm. When the hole transport layer 5 has a thickness of greater than or equal to 1 nm and less than or equal to 1000 nm, it sufficiently exhibits a hole transport property. In addition, when the hole transport layer 5 has a thickness of greater than or equal to 1 nm and less than or equal to 1000 nm, the hole transport layer 5 has a low resistance, so that light is efficiently converted into electricity.

The hole transport layer 5 may contain a supporting electrolyte and a solvent. The supporting electrolyte and the solvent stabilize holes in the hole transport layer 5.

Examples of the supporting electrolyte include ammonium salts and alkali metal salts. Examples of the ammonium salts include tetrabutylammonium perchlorate, tetraethylammonium hexafluorophosphate, imidazolium salts, and pyridinium salts. Examples of the alkali metal salts include Lithium bis(trifluoromethanesulfonyl)imide (hereafter, referred to as "LiTFSI"), LiPF₆, LiBF₄, lithium perchlorate, and potassium tetrafluoroborate.

The solvent contained in the hole transport layer 5 may have a high ion conductivity. The solvent may be an aqueous solvent or an organic solvent. From the viewpoint of stabilization of the solute, organic solvents are desirable. Examples of the organic solvents include heterocyclic compounds such as tert-butylpyridine, pyridine, and n-methylpyrrolidone.

The solvent contained in the hole transport layer 5 may be an ionic liquid. The ionic liquid may be used alone or as a mixture further containing another solvent. The ionic liquid is desirable from the viewpoint of low volatility and high flame retardancy.

Examples of the ionic liquid include imidazolium compounds such as 1-ethyl-3-methylimidazolium tetracyanoborate, pyridine compounds, alicyclic amine compounds, aliphatic amine compounds, and azonium amine compounds.

### (Operations and Effects of solar cell)

Hereinafter, basic operations of the solar cell 100 will be described. When the solar cell 100 is irradiated with light, the photoelectric conversion layer 4 absorbs light, to generate excited electrons and holes within the photoelectric conversion layer 4. These excited electrons move to the electron transport layer 3. On the other hand, the holes generated in the photoelectric conversion layer 4 move to the hole transport layer 5. The electron transport layer 3 is connected to the first electrode 2, and the hole transport layer 5 is connected to the second electrode 6. Thus, current is produced between the first electrode 2 functioning as the negative electrode and the second electrode 6 functioning as the positive electrode.

### (Method for producing solar cell 100)

The solar cell 100 can be produced by, for example, the following method.

First, on a surface of a substrate 1, a first electrode 2 is formed by a chemical vapor deposition method (hereafter, referred to as "CVD method") or a sputtering method.

Subsequently, on the first electrode 2, an electron transport layer 3 is formed by a coating method such as a spin coating method or a sputtering method.

In the case of the spin coating method, a Nb raw material is dissolved in a solvent to prepare a solution. Examples of the Nb raw material include niobium alkoxides (such as niobium ethoxide), halogenated niobium, niobium ammonium oxalate, and niobium hydrogen oxalate. Examples of the solvent include isopropanol and ethanol.

Subsequently, the solution is applied onto the first electrode 2 by a spin coating method, to form a thin film. The thin film is baked in the air at a temperature of greater than or equal to 30°C and less than or equal to 1500°C.

On the electron transport layer 3, a photoelectric conversion layer 4 is formed. The photoelectric conversion layer 4 can be formed, for example, in the following manner. Hereinafter, as an example, a method of forming the photoelectric conversion layer 4 containing a perovskite compound represented by (HC(NH₂)₂)_{1-y-z}(C₆H₅CH₂CH₂NH₃)_{y}(CH₆N₃)_{z}SnI₃ (where 0 < y, 0 < z, and 0 < y + z < 1, hereafter, referred to as "FA_{1-y-z}PEA_{y}GA_{z}SnI₃") will be described.

First, to an organic solvent, SnI₂, HC(NH₂)₂I (hereafter, referred to as "FAI"), C₆H₅CH₂CH₂NH₃I (hereafter, referred to as "PEAI"), and CH₆N₃I (hereafter, referred to as "GAI") are added, to obtain a liquid mixture. The organic solvent is, for example, a mixture (volume ratio = 1:1) of dimethyl sulfoxide (hereafter, referred to as "DMSO") and N,N-dimethylformamide (hereafter, referred to as "DMF").

SnI₂ may have a molarity of greater than or equal to 0.8 mol/L and less than or equal to 2.0 mol/L, or greater than or equal to 0.8 mol/L and less than or equal to 1.5 mol/L.

FAI may have a molarity of greater than or equal to 0.8 mol/L and less than or equal to 2.0 mol/L, or greater than or equal to 0.8 mol/L and less than or equal to 1.5 mol/L.

PEAI may have a molarity of greater than or equal to 0.1 mol/L and less than or equal to 0.6 mol/L, or greater than or equal to 0.3 mol/L and less than or equal to 0.5 mol/L.

GAI may have a molarity of greater than or equal to 0.1 mol/L and less than or equal to 0.6 mol/L, or greater than or equal to 0.3 mol/L and less than or equal to 0.5 mol/L.

Subsequently, the liquid mixture is heated at a temperature of greater than or equal to 40°C and less than or equal to 180°C. In this way, the solution mixture in which SnI₂, FAI, PEAI, and GAI dissolve is obtained. Subsequently, the solution mixture is left at room temperature.

Subsequently, the solution mixture is applied onto the electron transport layer 3 by a spin coating method, to form a coating film. Subsequently, the coating film is heated at a temperature of greater than or equal to 40°C and less than or equal to 100°C for longer than or equal to 15 minutes and shorter than or equal to 1 hour. This forms the photoelectric conversion layer 4. When the spin coating method is performed to apply the solution mixture, a poor solvent may be added dropwise during the spin coating. Examples of the poor solvent include toluene, chlorobenzene, and diethyl ether.

The solution mixture may contain a quencher substance such as tin fluoride. The concentration of the quencher substance may be greater than or equal to 0.05 mol/L and less than or equal to 0.4 mol/L. The quencher substance suppresses generation of defects within the photoelectric conversion layer 4. The cause of generation of defects within the photoelectric conversion layer 4 is, for example, an increase in the amount of Sn vacancies due to an increase in the amount of Sn⁴⁺.

On the photoelectric conversion layer 4, a hole transport layer 5 is formed. The hole transport layer 5 is formed by, for example, a coating method or a printing method. Examples of the coating method include a doctor blade method, a bar coating method, a spraying method, a dip coating method, and a spin coating method. Examples of the printing method include a screen printing method. A plurality of materials may be mixed for obtaining the hole transport layer 5, and then the hole transport layer 5 may be pressed or baked. When the material for the hole transport layer 5 is a low-molecular-weight organic substance or an inorganic semiconductor, a vacuum deposition method may be performed to form the hole transport layer 5.

Finally, on the hole transport layer 5, a second electrode 6 is formed. In this way, the solar cell 100 is obtained. The second electrode 6 can be formed by a CVD method or a sputtering method.

### <Findings on which the present disclosure is based>

The findings on which the present disclosure is based are as follows.

The tin-based perovskite compound has a band gap of about 1.4 eV, and hence the tin-based perovskite compound is suitable as the photoelectric conversion material for solar cells. Existing tin-based perovskite solar cells have a high theoretical photoelectric conversion efficiency; however, existing tin-based perovskite solar cells actually have a lower photoelectric conversion efficiency than lead-based perovskite solar cells.

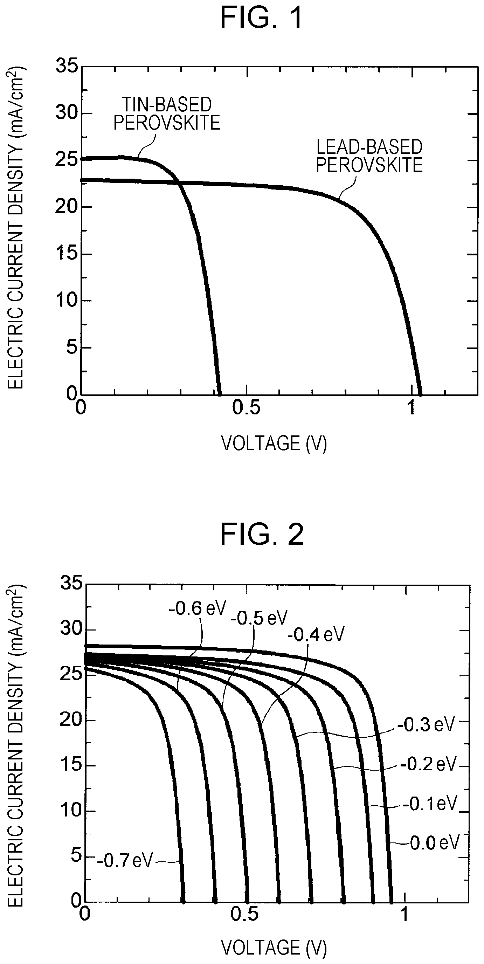

Fig. 1 is a graph illustrating the measured values of the photoelectric conversion efficiency of a lead-based perovskite solar cell and a tin-based perovskite solar cell produced by an inventor of the present invention. The lead-based perovskite solar cell and the tin-based perovskite solar cell had a layered structure of substrate/first electrode/electron transport layer/porous layer/photoelectric conversion layer/hole transport layer/second electrode. The following is the detailed descriptions of the lead-based perovskite solar cell and the tin-based perovskite solar cell.

### (Lead-based perovskite solar cell)

Substrate: glass substrate
First electrode: mixture of indium-tin double oxide (ITO) and antimony-doped tin oxide (ATO)
   Electron transport layer: compact TiO₂ (c-TiO₂)
   Porous layer: meso-porous TiO₂ (mp-TiO₂)
   Photoelectric conversion layer: HC(NH₂)₂PbI₃
   Hole transport layer: spiro-OMeTAD (2,2',7,7'-tetrakis-(N,N-di-p-methoxyphenylamine)9,9'-spirobifluorene)
   Second electrode: gold

### (Tin-based perovskite solar cell)

Substrate: glass substrate
First electrode: mixture of indium-tin double oxide (ITO) and antimony-doped tin oxide (ATO)
Electron transport layer: compact TiO₂ (c-TiO₂)
Porous layer: meso-porous TiO₂ (mp-TiO₂)
Photoelectric conversion layer: HC(NH₂)₂SnI₃
Hole transport layer: PTAA (poly[bis(4-phenyl)(2,4,6-trimethylphenyl)amine]) Second electrode: gold

Fig. 1 demonstrates that the existing tin-based perovskite solar cell has a lower open-circuit voltage than the lead-based perovskite solar cell. This inferentially causes the existing tin-based perovskite solar cell to have a lower photoelectric conversion efficiency than the lead-based perovskite solar cell. The open-circuit voltage is low inferentially because the electron transport material and the tin-based perovskite compound have a large difference in the energy level of the bottom of the conduction band, and carriers recombine at the interface between the electron transport layer and the photoelectric conversion layer.

Hereinafter, "difference between the photoelectric conversion material and the electron transport material in the energy level of the bottom of the conduction band" is defined as "energy offset". Specifically, the energy offset is a value obtained by subtracting "the energy level of the bottom of the conduction band of the photoelectric conversion material" from "the energy level of the bottom of the conduction band of the electron transport material". In this Description, the value of "the energy level of the bottom of the conduction band" is a value determined with respect to the vacuum level.

The tin-based perovskite compound has a conduction band at the bottom of which the energy level may be -3.5 eV. On the other hand, the lead-based perovskite compound has a conduction band at the bottom of which the energy level may be -4.0 eV. Thus, the bottom of the conduction band of the tin-based perovskite compound is located shallower than the bottom of the conduction band of the lead-based perovskite compound. The representative electron transport material used in the lead-based perovskite solar cell is TiO₂. The energy level of at the bottom of the conduction band of TiO₂ is -4.0 eV. Thus, in the tin-based perovskite solar cell, when TiO₂ is used as the electron transport material to form the electron transport layer, an energy difference (namely, energy offset) is generated at the interface between the electron transport material and the tin-based perovskite compound. For example, at the interface between TiO₂ and the tin-based perovskite compound, the difference between the energy levels at the bottom of the conduction bands causes an energy offset of -0.5 eV. The presence of the energy offset increases the probability of the presence of electrons at and near the interface. This results in an increase in the probability of recombination of carriers at the interface, which causes loss of the open-circuit voltage. In summary, in the case of using the same electron transport material (specifically, TiO₂) as in the Pb-based perovskite solar cell to form the tin-based perovskite solar cell, the open-circuit voltage decreases as described above. This results in a decrease in the photoelectric conversion efficiency of the solar cell.

Fig. 2 is a graph illustrating the relationship among (i) variations in the energy offset between the photoelectric conversion layer and the electron transport layer of a solar cell, (ii) the voltage of the solar cell, and (iii) the electric current density of the solar cell. The graph illustrates results calculated by device simulation (software name: SCAPS). Fig. 2 illustrates the results of simulation where the energy offset between the photoelectric conversion layer and the electron transport layer is 0.0 eV, -0.1 eV, -0.2 eV, -0.3 eV, -0.4 eV, -0.5 eV, -0.6 eV, or -0.7 eV. As is clear from Fig. 2, in order to achieve a high efficiency (for example, an electric current density of greater than or equal to 27 mA/cm² at a voltage of 0.7 V), the absolute value of the energy offset needs to be less than or equal to 0.3 eV. Thus, there is a demand for a novel electron transport material suitable for the tin-based perovskite compound.

The inventors of the present invention have found that, in the tin-based perovskite solar cell, in order to reduce the energy offset between the photoelectric conversion layer and the electron transport layer, the following features (i) and (ii) need to be satisfied:
(i) the electron transport layer contains an electron transport material containing niobium oxide; and
(ii) the niobium oxide is amorphous.

Niobium oxide has an electron affinity close to the electron affinity of the tin-based perovskite compound.

On the basis of these findings, the inventors of the present invention provide a solar cell that contains a tin-based perovskite compound and that has a low energy offset.

### (EXAMPLES)

Hereinafter, the present disclosure will be described further in detail with reference to Examples below. As described below, in Example 1 to Example 6 and Comparative Example 1 to Comparative Example 7, solar cells including an electron transport layer and a photoelectric conversion layer containing a perovskite compound were produced. In addition, properties of the solar cells were evaluated. The solar cells in Example 1 to Example 6 and Comparative Examples 1 to 5 and 7 were tin-based perovskite solar cells having the same structure as in the perovskite solar cell 100 in Fig. 3. The solar cell in Comparative Example 6 also had the same structure as in the perovskite solar cell 100 in Fig. 3. Note that the solar cell in Comparative Example 6 is not a tin-based lead perovskite solar cell, but a based perovskite solar cell.

### (Example 1)

A glass substrate (manufactured by Nippon Sheet Glass Co., Ltd.) having an indium-doped SnO₂ layer in the surface was prepared. The glass substrate and the SnO₂ layer respectively functioned as the substrate 1 and the first electrode 2. The glass substrate had a thickness of 1 mm.

An ethanol solution containing niobium ethoxide (manufactured by Sigma-Aldrich Corporation) represented by a chemical formula Nb(OCH₂CH₃)₅ was prepared. This ethanol solution had a niobium ethoxide concentration of 0.05 mol/L. This ethanol solution (80 µl) was applied onto the first electrode 2 by a spin coating method, to obtain a coating film. This coating film was subjected to preliminary baking on a hot plate at a temperature of 120°C for 30 minutes, and subsequently to main baking at a temperature of 700°C for 30 minutes. In this way, an electron transport layer 3 constituted by an amorphous Nb₂O₅ film was formed. The electron transport layer 3 had a thickness of 8 nm.

A solution containing SnI₂, SnF₂, FAI, PEAI, and GAI (all manufactured by Sigma-Aldrich Corporation) was prepared. This solution respectively had SnI₂, SnF₂, FAI, PEAI, and GAI concentrations of 1.5 mol/L, 0.15 mol/L, 1.5 mol/L, 0.41 mol/L, and 0.47 mol/L. The solvent of the solution was a mixture of DMSO (specifically, dimethyl sulfoxide) and DMF (specifically, N,N-dimethylformamide) (DMSO:DMF = 7:3 (volume ratio)).

Within a glove box, this solution (80 µl) was applied onto the electron transport layer 3 by a spin coating method, to obtain a coating film. The coating film had a thickness of 500 nm.

The coating film was baked on a hot plate at a temperature of 120°C for 30 minutes, to form a photoelectric conversion layer 4. The photoelectric conversion layer 4 mainly contained a perovskite compound represented by a composition formula FA_{0.63}PEA_{0.17}GA_{0.2}SnI₃. The perovskite compound represented by the composition formula FA_{0.63}PEA_{0.17}GA_{0.2}SnI₃ had a conduction band at the bottom of which the energy level with respect to the vacuum level was -3.57 eV. The energy level of the bottom of the conduction band of the perovskite compound was measured by a method similar to a method of measuring the energy level of the bottom of the conduction band of the electron transport material described later under the heading "Measurement of energy offset".

Within a glove box, a toluene solution (80 µl) containing PTAA (specifically, poly[bis(4-phenyl)(2,4,6-trimethylphenyl)amine], manufactured by Sigma-Aldrich Corporation) at a concentration of 10 mg/mL was applied onto the photoelectric conversion layer 4 by a spin coating method, to form a hole transport layer 5. Observation using a cross-sectional SEM analyzer (apparatus name: Helios G3, manufactured by FEI Company) revealed that the hole transport layer 5 had a thickness of 10 nm.

Finally, on the hole transport layer 5, a gold film having a thickness of 100 nm was vapor-deposited, to form a second electrode 6. In this way, a solar cell of Example 1 was obtained.

### [Example 2]

In Example 2, the solar cell of Example 2 was obtained by the same method as in Example 1 except that, in the formation of the electron transport layer 3, the ethanol solution had a niobium ethoxide concentration of 0.3 mol/L. The electron transport layer 3 had a thickness of 50 nm.

### [Example 3]

In Example 3, the solar cell of Example 3 was obtained by the same method as in Example 1 except that, in the formation of the electron transport layer 3, the ethanol solution had a niobium ethoxide concentration of 0.3 mol/L, and, prior to the main baking, the application of the ethanol solution was repeated five times. The electron transport layer 3 had a thickness of 250 nm.

### [Example 4]

In Example 4, the solar cell of Example 4 was obtained by the same method as in Example 1 except that, in the formation of the electron transport layer 3, the ethanol solution had a niobium ethoxide concentration of 0.3 mol/L, and, prior to the main baking, the application of the ethanol solution was repeated seven times. The electron transport layer 3 had a thickness of 350 nm.

### [Example 5]

In Example 5, the solar cell of Example 5 was obtained by the same method as in Example 1 except that, in the formation of the electron transport layer 3, the ethanol solution had a niobium ethoxide concentration of 0.01 mol/L. The electron transport layer 3 had a thickness of 2 nm.

### [Example 6]

In Example 6, the solar cell of Example 6 was obtained by the same method as in Example 1 except that, in the formation of the electron transport layer 3, the ethanol solution had a niobium ethoxide concentration of 0.3 mol/L, and, prior to the main baking, the application of the ethanol solution was repeated 11 times. The electron transport layer 3 had a thickness of 550 nm.

### [Comparative Example 1]

In Comparative Example 1, the solar cell of Comparative Example 1 was obtained by the same method as in Example 1 except that, on the first electrode 2, a titanium oxide film (specifically, a TiO₂ film) was formed by a sputtering method to form the electron transport layer 3. The electron transport layer 3 had a thickness of 20 nm.

### [Comparative Example 2]

In Comparative Example 2, the solar cell of Comparative Example 2 was obtained by the same method as in Example 1 except that the ethanol solution containing niobium ethoxide was replaced by an ethanol solution containing 0.3 mol/L of aluminum nitrate represented by a chemical formula Al(NO₃)₃ (manufactured by FUJIFILM Wako Pure Chemical Corporation) to form the electron transport layer 3. The electron transport layer 3 had a thickness of 100 nm.

### [Comparative Example 3]

In Comparative Example 3, the solar cell of Comparative Example 3 was obtained by the same method as in Example 1 except that the ethanol solution containing niobium ethoxide was replaced by an ethanol solution containing 0.3 mol/L of zirconium acetate dihydrate represented by a chemical formula ZrOCOCH₃·2H₂O (manufactured by Sigma-Aldrich Corporation) to form the electron transport layer 3. The electron transport layer 3 had a thickness of 100 nm.

### [Comparative Example 4]

In Comparative Example 4, the solar cell of Comparative Example 4 was obtained by the same method as in Example 1 except that the ethanol solution containing niobium ethoxide was replaced by an ethanol solution containing 0.3 mol/L of zinc chloride represented by a chemical formula ZnCl₂ (manufactured by FUJIFILM Wako Pure Chemical Corporation) to form the electron transport layer 3. The electron transport layer 3 had a thickness of 50 nm.

### [Comparative Example 5]

In Comparative Example 5, the solar cell of Comparative Example 5 was obtained by the same method as in Example 1 except that the ethanol solution containing niobium ethoxide was replaced by an ethanol solution containing 0.3 mol/L of tantalum ethoxide represented by a chemical formula Ta(OCH₂CH₃)₅ (manufactured by Sigma-Aldrich Corporation) to form the electron transport layer 3. The electron transport layer 3 had a thickness of 50 nm.

### [Comparative Example 6]

In Comparative Example 6, the solar cell of Comparative Example 6 was obtained by the same method as in Example 1 except for the following three features (i) to (iii):
(i) in the formation of the electron transport layer 3, the ethanol solution had a niobium ethoxide concentration of 0.3 mol/L;
(ii) in the formation of the photoelectric conversion layer 4, SnI₂ was replaced by PbI₂; and
(iii) in the formation of the photoelectric conversion layer 4, SnF₂ was not added.

The electron transport layer 3 had a thickness of 50 nm.

### [Comparative Example 7]

In Comparative Example 7, the solar cell of Comparative Example 7 was obtained by the same method as in Example 1 except that the coating film was subjected to main baking at a temperature of 850°C for 60 minutes to form the electron transport layer 3.

In Comparative Example 7, the electron transport layer 3 had a thickness of 250 nm.

### [Measurement of thickness of electron transport layer]

In Examples and Comparative Examples, the thicknesses of the electron transport layers 3 were measured using a surface profiler (Dektak 150 (Bruker)) in the following manner.

In each of Examples and Comparative Examples, a sample (mensurative sample) constituted by the substrate 1, the first electrode 2, and the electron transport layer 3 was prepared. The sample did not include the photoelectric conversion layer 4, the hole transport layer 5, or the second electrode 6. Thus, the surface of the electron transport layer 3 was exposed. The thickness of the electron transport layer 3 included in the sample was measured using the surface profiler.

### (Determination as to whether niobium oxide is amorphous or crystalline)

The samples of Example 3 and Comparative Example 7 were subjected to X-ray diffractometry using an X-ray diffractometer (manufactured by Rigaku Corporation, apparatus name: SmartLab). In the X-ray diffractometry, CuKα radiation having a wavelength of 0.15405 nm was used.

Fig. 4 is a graph illustrating X-ray diffraction patterns of the samples of Example 3 and Comparative Example 7. As illustrated in Fig. 4, the sample of Comparative Example 7 has three peaks at diffraction angles 2θ of about 14°, about 28°, and about 32°. On the other hand, the sample of Example 3 does not have peaks. As is well-known in the technical field of X-ray diffraction patterns, the presence of peaks means that the sample has crystallinity (more specifically, the sample has a crystalline structure orientation). The sample of Example 3 does not have peaks, so that the sample of Example 3 is determined as being amorphous. On the other hand, the sample of Comparative Example 7 has peaks, so that the sample of Comparative Example 7 is determined as being crystalline.

Note that, in each of Example 3 and Comparative Example 7, the electron transport layer 3 had a thickness of 250 nm.

### [Measurement of composition]

In each of Examples and Comparative Examples, the composition of the electron transport material contained in the electron transport layer 3 included in the sample was determined using an X-ray photoelectron spectrometer (manufactured by ULVAC-PHI, Inc., trade name: PHI 5000 VersaProbe).

### [Measurement of energy offset]

In each of Examples and Comparative Examples, the energy offset for the bottom of the conduction band of the electron transport material contained in the electron transport layer 3 included in the sample was measured by ultraviolet electron spectroscopy and transmittance measurement method. The energy offset for the bottom of the conduction band of the photoelectric conversion material contained in the photoelectric conversion layer 4 included in the solar cell was measured by ultraviolet electron spectroscopy and transmittance measurement method.

Each sample was subjected to ultraviolet electron spectroscopy using an ultraviolet electron spectrometer (manufactured by ULVAC-PHI, Inc., trade name: PHI 5000 VersaProbe), to obtain the value of the energy level of the top of the valence band of the electron transport material.

Each sample was subjected to transmittance measurement using a transmittance measurement apparatus (manufactured by SHIMADZU CORPORATION, trade name: SlidSpec-3700)); subsequently, from the result of the transmittance measurement, the value of band gap of the electron transport material was obtained.

From the value of the energy level of the top of the valence band and the value of the band gap obtained in the above-described manner, the energy level of the bottom of the conduction band of the electron transport material was calculated.

From the calculated energy level of the bottom of the conduction band of the electron transport material, -3.57 eV, which is equal to the energy level of the bottom of the conduction band of the FA_{0.63}PEA_{0.17}GA_{0.2}SnI₃ perovskite compound functioning as a photoelectric conversion material, was subtracted, to provide the energy offset.

### [Evaluation of photoelectric conversion efficiency]

Each of the solar cells of Examples and Comparative Examples was irradiated with simulated sunlight having an illuminance of 100 mW/cm² from a solar simulator, and the photoelectric conversion efficiency of each solar cell was measured.

Table 1 describes, for each of Examples and Comparative Examples, the electron transport material contained in the electron transport layer, the photoelectric conversion material contained in the photoelectric conversion layer, and energy offset between the photoelectric conversion layer and the electron transport layer.

As is clear from comparison of Example 1 with Comparative Examples 1, 4, 6, and 7, the energy offset between the FA_{0.63}PEA_{0.17}GA_{0.2}SnI₃ tin-based perovskite compound and Nb₂O₅ is smaller than the energy offset between the FA_{0.63}PEA_{0.17}GA_{0.2}SnI₃ tin-based perovskite compound and any of the other oxides.

On the other hand, as is clear from comparison of Example 1 with Comparative Example 6, the FA_{0.63}PEA_{0.17}GA_{0.2}PbI₃ lead-based perovskite compound has a conduction band at the bottom of which the energy level is deeper than the energy level of the bottom of the conduction band of the tin-based perovskite compound; the energy offset between the FA_{0.63}PEA_{0.17}GA_{0.2}PbI₃ lead-based perovskite compound and Nb₂O₅ is larger than the energy offset between the FA_{0.63}PEA_{0.17}GA_{0.2}SnI₃ tin-based perovskite compound and Nb₂O₅.

Table 2 describes, for each of the solar cells of Examples and Comparative Examples, the electron transport material, the photoelectric conversion material, the thickness of the electron transport layer, the Nb/O ratio (molar ratio) in the electron transport layer, and photoelectric conversion efficiency.

As is clear from comparison of Example 1 with Comparative Example 1 to Comparative Example 5, when the electron transport material is Nb₂O₅, the solar cell has a high photoelectric conversion efficiency. This is because the energy offset between Nb₂O₅ and the tin-based perovskite compound is small. On the other hand, when the electron transport material is a material other than Nb₂O₅, the solar cell has a low photoelectric conversion efficiency.

As is clear from comparison of Example 1 with Comparative Example 6, when the photoelectric conversion material is the Pb-based perovskite compound, even when Nb₂O₅ is used as the electron transport material, the solar cell has a low photoelectric conversion efficiency. This is because the energy offset between Nb₂O₅ and the lead-based perovskite compound is large.

Referring to Comparative Example 5, in spite of the small energy offset of +0.3 eV, in the case of using, as the electron transport material, Ta₂O₅, the photoelectric conversion efficiency is low. This is inferentially because Ta₂O₅ has a low electric conductivity, so that the electron transport layer 3 does not function.

**[Table 1]**

| | Electron transport material | Photoelectric conversion material | Offset between electron transport layer and photoelectric conversion layer (eV) |
|---|---|---|---|
| Example 1 | Nb₂O₅ | FA_{0.63}PEA_{0.17}GA_{0.2}SnI₃ | +0.1 |
| Com parative Example 1 | TiO₂ | FA_{0.63}PEA_{0.17}GA_{0.2}SnI₃ | -0.5 |
| Com parative Example 2 | ZrO₂ | FA_{0.63}PEA_{0.17}GA_{0.2}SnI₃ | +0.9 |
| Com parative Example 6 | ZnO | FA_{0.63}PEA_{0.17}GA_{0.2}SnI₃ | -0.7 |
| Com parative Example 7 | Ta₂O₅ | FA_{0.63}PEA_{0.17}GA_{0.2}SnI₃ | +0.3 |
| Com parative Example 8 | Nb₂O₅ | FA_{0.63}PEA_{0.17}GA_{0.2}PbI₃ | +0.5 |

**[Table 2]**

| | Electron transport material | Crystallinity of electron transport material | Photoelectric conversion material | Thickness of electron transport layer (nm) | Nb/O ratio (molar ratio) in electron transport layer | Conversion efficiency (%) |
|---|---|---|---|---|---|---|
| Example 1 | Nb₂O₅ | Amorphous | FA_{0.63}PEA_{0.17}GA_{0.2}SnI₃ | 8 | 0.38 | 2.39 |
| Example 2 | Nb₂O₅ | Amorphous | FA_{0.63}PEA_{0.17}GA_{0.2}SnI₃ | 50 | 0.39 | 2.62 |
| Example 3 | Nb₂O₅ | Amorphous | FA_{0.63}PEA_{0.17}GA_{0.2}SnI₃ | 250 | 0.39 | 3.03 |
| Example 4 | Nb₂O₅ | Amorphous | FA_{0.63}PEA_{0.17}GA_{0.2}SnI₃ | 350 | 0.38 | 2.61 |
| Example 5 | Nb₂O₅ | Amorphous | FA_{0.63}PEA_{0.17}GA_{0.2}SnI₃ | 2 | 0.38 | 1.32 |
| Example 6 | Nb₂O₅ | Amorphous | FA_{0.63}PEA_{0.17}GA_{0.2}SnI₃ | 550 | 0.38 | 1.46 |
| Com parative Example 1 | TiO₂ | - | FA_{0.63}PEA_{0.17}GA_{0.2}SnI₃ | 20 | 0.00 | 2.04 |
| Com parative Example 2 | ZrO2 | - | FA_{0.63}PEA_{0.17}GA_{0.2}SnI₃ | 100 | 0.00 | 0.00 |
| Com parative Example 3 | Al₂O₃ | - | FA_{0.63}PEA_{0.17}GA_{0.2}SnI₃ | 100 | 0.00 | 0.00 |
| Com parative Example 4 | ZnO | - | FA_{0.63}PEA_{0.17}GA_{0.2}SnI₃ | 50 | 0.00 | 0.00 |
| Com parative Example 5 | Ta₂O₅ | - | FA_{0.63}PEA_{0.17}GA_{0.2}SnI₃ | 50 | 0.00 | 0.00 |
| Com parative Example 6 | Nb₂O₅ | Amorphous | FA_{0.63}PEA_{0.17}GA_{0.2}PbI₃ | 50 | 0.38 | 0.30 |
| Com parative Example 7 | Nb₂O₅ | Crystalline | FA_{0.63}PEA_{0.17}GA_{0.2}SnI₃ | 250 | 0.38 | 0.25 |

As is clear from Table 1 and Table 2, the solar cells that satisfy the following conditions (i) to (iii) have a photoelectric conversion efficiency of greater than or equal to 1%:
Condition (i): the photoelectric conversion material is not a lead-based perovskite compound but a tin-based perovskite compound (compare Example 1 to Example 6 with Comparative Example 6);
Condition (ii): the electron transport layer 3 contains an electron transport material containing niobium oxide (compare Example 1 to Example 6 with Comparative Example 1 to Comparative Example 5); and
Condition (iii): the niobium oxide is amorphous (compare Example 1 to Example 6 with Comparative Example 7).

In addition, as is clear from Table 1 and Table 2, the solar cells that satisfy, in addition to the above-described Conditions (i) to (iii)3, the following Condition (iv) have a photoelectric conversion efficiency of greater than or equal to 2%:
Condition (iv): the electron transport layer 3 has a thickness of greater than or equal to 8 nm and less than or equal to 350 nm (compare Example 1 to Example 4 with Example 5 to Example 6).

### Industrial Applicability

The solar cell according to the present disclosure achieves a high photoelectric conversion efficiency. In addition, the solar cell according to the present disclosure is advantageous from an environmental perspective. Thus, the solar cell according to the present disclosure is disposed on, for example, a roof, a wall surface, or an automobile.

### Reference Signs List

- 1: substrate
- 2: first electrode
- 3: electron transport layer
- 4: photoelectric conversion layer
- 5: hole transport layer
- 6: second electrode
- 100: solar cell

## Claims

1. A solar cell comprising:
a first electrode;
a second electrode;
a photoelectric conversion layer disposed between the first electrode and the second electrode; and
an electron transport layer disposed between the first electrode and the photoelectric conversion layer,
wherein at least one of the first electrode and the second electrode has a light-transmitting property,
the photoelectric conversion layer contains a perovskite compound composed of a monovalent cation, a Sn cation, and a halogen anion,
the electron transport layer contains an electron transport material containing niobium oxide, and
the niobium oxide is amorphous.

2. The solar cell according to Claim 1,
wherein the electron transport layer has a thickness of greater than or equal to 8 nm and less than or equal to 350 nm.

3. The solar cell according to Claim 2,
wherein the electron transport layer has a thickness of greater than or equal to 10 nm and less than or equal to 350 nm.

4. The solar cell according to Claim 3,
wherein the electron transport layer has a thickness of greater than or equal to 50 nm and less than or equal to 350 nm.

5. The solar cell according to any one of Claims 1 to 4,
wherein the niobium oxide has a molar ratio of niobium to oxygen of greater than or equal to 0.36 and less than or equal to 0.41.

6. The solar cell according to any one of Claims 1 to 5,
wherein the niobium oxide is represented by a chemical formula Nb₂O₅.

7. The solar cell according to any one of Claims 1 to 6,
wherein the monovalent cation includes a formamidinium cation.

8. The solar cell according to any one of Claims 1 to 7,
wherein the halogen anion includes an iodide ion.
